# DEMANDE DE BREVET EUROPEEN

(11) **EP 3 263 735 A1**
(43) Date de publication de la demande: **03.01.2018**
(21) Numéro de dépôt: 17177827.7
(22) Date de dépôt: 26.06.2017
(51) Int. Cl.: C23C 14/00, C23C 14/08, C23C 14/20, C23C 14/58, C08J 7/00, F21V 7/22, C23C 28/00, C23C 14/18, F21S 8/10, B23K 101/34

(54) **PIÈCE MÉTALLISÉE COMPRENANT UNE COUCHE D'OXYDE DE CUIVRE**

(30) Priorité: 30.06.2016 FR 1656245
(71) Demandeur: Valeo Vision, 93012 Bobigny Cedex (FR)
(72) Inventeur: CORBINEAU, Julien, 49000 ANGERS (FR); BELLIER, Alexandre, 49000 ANGERS (FR)

(57) **Abrégé**

La présente invention concerne une pièce métallisée (1) comprenant au moins un support (2), caractérisée en ce qu'elle comprend en outre au moins une couche métallisée (3) comprenant au moins du cuivre et de l'oxygène, la couche métallisée (3) recouvrant au moins en partie le support (2).

## Description

L'invention se rapporte à une pièce métallisée comprenant un support et une couche métallisée ainsi qu'à un procédé de fabrication d'une telle pièce, la pièce métallisée étant notamment une pièce de véhicule automobile.

Dans le domaine des véhicules automobiles, de nombreuses pièces ayant des fonctions et des formes différentes sont utilisées. Ces pièces peuvent être constituées de divers matériaux comme par exemple des matériaux polymères ou des matériaux métalliques. Un besoin existe pour conférer à ces pièces un aspect métallisé et ce, quelle que soit la forme de la pièce et le matériau qui la constitue.

Des procédés existent dans l'art antérieur permettant de recouvrir des pièces par une couche leur donnant un aspect métallisé, cette couche pouvant être colorée. Une méthode connue consiste à recouvrir la pièce d'une couche d'aluminium par métallisation sous vide puis de recouvrir la couche d'aluminium par un verni pigmenté. Une autre méthode pouvant être utilisée est la pulvérisation cathodique ou « sputter deposition » de dioxyde de titane.

Cependant, les méthodes de l'art antérieur peuvent présenter plusieurs inconvénients, comme par exemple, le dégagement de composés volatils, la nécessité d'installations volumineuses et/ou un coût de fabrication élevé. De plus, l'aspect extérieur de la pièce ainsi traitée peut ne pas être homogène, en particulier dans le cas où la pièce possède une forme complexe avec différents reliefs rendant difficile l'application d'une couche d'épaisseur constante sur toute la surface de la pièce.

Le but de la présente invention est de pallier les inconvénients de l'art antérieur en proposant des pièces ayant un aspect métallisé homogène sur toute la surface traitée à l'aide d'un procédé facile à mettre en oeuvre.

La présente invention a pour premier objet une pièce métallisée comprenant au moins un support, caractérisée en ce qu'elle comprend en outre au moins une couche métallisée comprenant au moins du cuivre et de l'oxygène, la couche métallisée recouvrant au moins en partie le support.

Avantageusement, le support recouvert par la couche métallisée présente un aspect métallisé quel(s) que soi(en)t le(s) matériau(x) qui le constituent.

Par ailleurs, la couche métallisée de l'invention confère au support un aspect métallisé homogène sur toute la surface qu'elle recouvre. Ainsi, la couche métallisée peut conférer un aspect métallisé homogène même lorsqu'elle recouvre un support de forme complexe, comme par exemple, un support comportant des reliefs.

En outre, la couche métallisée est appliquée par un procédé facile à mettre en oeuvre et ne générant pas de composés organiques volatils.

### Support

Selon l'invention, le support peut comprendre au moins un matériau choisi parmi un matériau polymère, un matériau métallique, un matériau céramique, un matériau composite, et un de leurs mélanges.

Selon un mode de réalisation préféré, le support de l'invention peut comprendre au moins un matériau polymère pouvant être thermodurcissable ou thermoplastique.

Selon l'invention, le matériau polymère du support peut comprendre au moins un polymère choisi parmi le polycarbonate (PC), le polyméthacrylate de méthyle (PMMA), le polymère acrylonitrile butadiène styrène (ABS), le polytéréphtalate de butylène (PBT), le polyéthylène (PE), le polypropylène (PP), le polyamide (PA), et un de leurs mélanges. A titre d'exemple préféré de polymère, on peut citer le polycarbonate, commercialisé par les sociétés SABIC et BAYER, respectivement sous les références Lexan XHT3141 et APEC 1895.

Selon l'invention, le support peut en outre comprendre au moins un additif, notamment bien connu de l'homme du métier et pouvant être choisis parmi :
- des agents colorants tels que des pigments ;
- des agents anti-UV ;
- des agents de protection tels que des antioxydants ;
- des agents de mise en oeuvre, tels que des plastifiants, des lubrifiants, des huiles ;
- des agents de réticulation, tels que par exemple des peroxydes organiques ; et un de leurs mélanges.

Selon l'invention, le support peut être de n'importe quelle couleur.

Selon un mode de réalisation préféré de l'invention, le support peut avoir, selon la méthode CIELab, les valeurs de paramètres L*a*b* suivantes : 0 ≤ L* ≤ 100, -50 ≤ a* ≤ +50 et, -50 ≤ b* ≤ +50, le paramètre L* définissant la clarté et les paramètres a* et b* définissant la chromaticité.

Selon un mode de réalisation particulièrement préféré, le support peut avoir, selon la méthode CIELab, les valeurs de paramètres L*a*b* suivantes : 25 ≤ L* ≤ 30, -1 ≤ a* ≤ +1 et, -1 ≤ b* ≤ +1. Selon ce mode de réalisation, le support est de couleur noire.

Selon l'invention, le support peut avoir une épaisseur moyenne allant de 1,0 µm (micromètre) à 100,0 mm (millimètre), de préférence de allant de 1,0 mm à 10,0 mm, et de façon particulièrement préférée allant de 2,0 mm à 3,0 mm.

Selon un mode de réalisation préféré de l'invention, le support peut subir un traitement de surface et/ou être revêtu d'une couche intermédiaire, permettant d'améliorer l'adhésion entre le support et la couche métallisée.

Selon l'invention, la couche intermédiaire peut comprendre au moins un matériau choisi parmi un matériau polymère, un matériau métallique, un matériau céramique, un matériau composite, et un de leurs mélanges.

La couche intermédiaire peut avoir une épaisseur moyenne allant de 1,0 nm (nanomètre) à 1,0 mm, de préférence allant de 5,0 nm à 100,0 µm, et de façon particulièrement préférée allant de 10,0 nm à 20,0 µm.

### Couche métallisée

Le support de l'invention est recouvert au moins en partie par la couche métallisée comprenant au moins du cuivre et de l'oxygène.

La détermination de la présence de cuivre et d'oxygène dans la couche métallisée peut être réalisée par la méthode MEB/EDS (Microscope Electronique à Balayage avec sonde pour spectroscopie à dispersion d'énergie) ou par la méthode MEB/EDX (Microscope Electronique à Balayage associée à la microanalyse par Energie Dispersive de rayons X).

Selon un mode de réalisation préféré, la couche métallisée peut comprendre un ou plusieurs groupement(s) cuivre-oxygène (Cu-O). Dans la présente invention, on entend par : « groupement cuivre-oxygène », un groupement comprenant au moins un atome de cuivre lié de façon covalente à un atome d'oxygène (Cu-O).

Dans un mode de réalisation particulier de l'invention, la couche métallisée peut comprendre au moins un oxyde de cuivre, de préférence choisi parmi l'oxyde de cuivre (I) (Cu₂O), l'oxyde de cuivre (II) (CuO), et un de leurs mélanges.

La couche métallisée peut en outre comprendre au moins un additif choisi parmi :
- des agents colorants tels que des pigments ;
- des agents anti-UV ;
- des agents de protection tels que des antioxydants ; et
- un de leurs mélanges.

Selon l'invention, la couche métallisée peut avoir une épaisseur moyenne allant de 1,0 nm à 10,0 µm, de préférence allant de 1,0 nm à 200,0 nm, et de façon particulièrement préférée allant de 5,0 nm à 100,0 nm.

### Pièce métallisée comprenant le support et la couche métallisée

Selon l'invention, la couche métallisée recouvre au moins en partie le support, et de préférence la couche métallisée recouvre totalement le support.

Selon un mode de réalisation préféré de l'invention, la couche métallisée peut être directement en contact physique avec le support, ou peut être directement en contact physique avec la couche intermédiaire déposée sur le support.

Selon l'invention, la couche métallisée peut avantageusement modifier l'aspect visuel du support. En particulier, le support, vue au travers de la couche métallisée, peut avoir un aspect métallisé et également une couleur différente de sa couleur d'origine.

Selon un mode de réalisation préféré de l'invention, le support est de couleur noire, et la couche métallisée lui donne un aspect métallisé bleu ou vert, et de préférence un aspect bleu au niveau de la ou des partie(s) du support recouverte(s) par la couche métallisée.

Selon ce mode de réalisation, la couche métallisée peut avoir, selon la méthode CIELab, les valeurs de paramètres L*a*b* suivantes : 40 ≤ L* ≤ 60, -6 ≤ a* ≤ +2 et, -20 ≤ b* ≤ -10, et de préférence 45 ≤ L* ≤ 55, -4 ≤ a* ≤ 0 et, -18 ≤ b* ≤ -12.

De façon avantageuse, l'aspect visuel du support vue au travers de la couche métallisée est homogène malgré les éventuels reliefs pouvant être présents sur le support.

Selon un mode de réalisation préféré de l'invention, la pièce métallisée peut être une pièce de véhicule automobile. Selon ce mode de réalisation, la pièce métallisée peut être, par exemple, un masque de module lumineux, un enjoliveur de système optique, ou une pièce de décoration intérieure ou extérieure à l'habitacle.

### Couche de protection

Selon un mode de réalisation préféré de l'invention, la pièce métallisée peut en outre comprendre une couche de protection recouvrant au moins en partie la couche métallisée.

Selon un mode de réalisation préféré de l'invention, la couche de protection peut recouvrir totalement la couche métallisée.

La couche de protection a pour fonction de protéger la couche métallisée, et en particulier de la protéger de l'humidité. En effet, l'humidité pourrait dégrader l'oxyde de cuivre contenu dans la couche métallisée, notamment par corrosion, et les propriétés de la couche métallisée seraient alors altérées par un changement d'aspect visuel et/ou mécanique. Ainsi, grâce à la couche de protection, les propriétés de la couche métallisée peuvent être stables dans le temps.

De façon avantageuse, la couche de protection peut-être transparente.

Dans la présente invention, on entend par « couche transparente », une couche transmettant la lumière par réfraction et au travers de laquelle les objets sont visibles avec plus ou moins de netteté. Plus particulièrement, c'est une couche à travers laquelle une image est observée sans perte significative de contraste : l'interposition de ladite couche transparente entre une image et un observateur de celle-ci ne réduit pas significativement la qualité de l'image. En effet, au sens de l'invention, une couche transparente peut transmettre au moins une partie de la lumière incidente (ou rayon lumineux incident) avec très peu voire sans dispersion. De préférence, la transmission lumineuse, notamment la transmission de la lumière visible, à travers la couche transparente est d'au moins 87%. La transmission lumineuse est la quantité de lumière que laisse passer la couche transparente à partir d'un rayon lumineux incident.

De façon avantageuse, la couche de protection transparente ne modifie sensiblement pas l'aspect visuel de la pièce métallisée qu'elle recouvre. Ainsi, une fois la couche de protection transparente déposée sur la pièce métallisée comportant le support et la couche métallisée, la couleur de la pièce est visible au travers de la couche de protection. La transparence de la couche de protection est telle que la couleur de la pièce métallisée, perçue à travers la couche de protection est sensiblement la même que la couleur de la pièce métallisée. La même couleur signifie que la variation des paramètres L*a*b selon la méthode CIELab respecte notamment les valeurs suivantes : ΔL ≤ 5,0, Δa ≤ 2,0, Δb ≤ 3,0, le paramètre L* définissant la clarté, les paramètres a* et b* définissant la chromaticité. Ainsi, l'aspect métallisé, et de préférence métallisé bleu dans le cas où le support est de couleur noire, conféré au support par la couche métallisée, n'est pas modifié par la présence de la couche de protection.

Selon un mode de réalisation particulièrement préféré de l'invention, la couche de protection peut être directement en contact physique avec la couche métallisée.

La couche de protection de l'invention peut avoir de préférence une épaisseur suffisante pour protéger la couche métallisée tout en ne modifiant sensiblement pas l'aspect visuel de la pièce métallisée vue à travers cette couche de protection. A titre d'exemple, la couche de protection peut avoir une épaisseur moyenne allant de 1,0 nm à 1,0 mm, de préférence allant de 5,0 nm à 100,0 µm, et de façon particulièrement préférée allant de 10,0 nm à 40,0 nm.

Selon l'invention, la couche de protection peut comprendre au moins un oxyde métallique, au moins un complexe céramique et/ou au moins un matériau polymère.

L'oxyde métallique peut être choisi parmi le dioxyde de titane (TiO₂), l'oxyde de zinc (ZnO), et un de leurs mélanges.

Le complexe céramique peut être choisi parmi le fluorure de magnésium (MgF₂), le dioxyde de silane (SiO₂), le dioxyde de zirconium (ZrO₂), le nitrure de silane (Si₃N₄), et un de leurs mélanges.

Le matériau polymère peut être choisi parmi un polymère acrylique, un polysiloxane, un polyuréthane, et un de leurs mélanges.

Le polysiloxane peut être plus particulièrement un polyorganosiloxane. Le polysiloxane peut avoir pour précurseur au moins un siloxane choisi parmi l'hexaméthyldisiloxane (HMDSO), l'octaméthylcyclotétrasiloxane (OMCTSO), le tétraméthyldisiloxane (TMDSO), le tétraéthyl orthosilicate (TEOS), et un de leurs mélanges.

Selon l'invention, la couche de protection peut comprendre au moins un additif choisi parmi :
- des agents colorants tels que des pigments ;
- des agents anti-UV ;
- des agents de protection antioxydants ;
- des agents de réticulation ;
- des agents de mise en oeuvre tels que des solvants ;
- des nanoparticules, ou charges métalliques ou non métalliques ; et
- un de leurs mélanges.

### Procédé

L'invention a pour deuxième objet un procédé de fabrication d'une pièce métallisée selon l'invention comprenant l'étape suivante :
i. former à partir de cuivre métallique (Cu⁽⁰⁾), sur au moins une partie du support, la couche métallisée comprenant au moins du cuivre et de l'oxygène, l'étape i comprenant au moins une étape de dépôt physique en phase vapeur.

Le procédé de fabrication de la pièce métallisé est un dépôt physique en phase vapeur connu sous l'anglicisme « Physical Vapor Déposition » (PVD), et peut être réalisé par évaporation thermique sous vide, pulvérisation cathodique (« sputter deposition »), ou évaporation par faisceau d'électrons (« electron beam évaporation »), et de préférence par évaporation thermique sous vide.

Le procédé de l'invention est facile à mettre en oeuvre et permet de déposer la couche métallisée en limitant de façon significative, voire en évitant les émissions de composés organiques volatils.

Selon un premier mode de réalisation, l'étape i du procédé de l'invention peut comprendre les étapes suivantes :
ia. déposer une couche de cuivre métallique (Cu⁽⁰⁾), sur au moins une partie du support, par dépôt physique en phase vapeur du cuivre métallique (Cu⁽⁰⁾), et
ib. oxyder le cuivre métallique (Cu⁽⁰⁾) de la couche déposée à l'étape ia pour former la couche métallisée.

Selon ce premier mode de réalisation, du cuivre métallique (Cu⁽⁰⁾) est tout d'abord déposé, à l'étape ia, sur le support par dépôt physique en phase vapeur, et de préférence par évaporation thermique sous vide.

Le dépôt de la couche de cuivre métallique (Cu⁽⁰⁾) à l'étape ia peut être réalisé :
- à partir de cuivre métallique (Cu⁽⁰⁾),
- chauffé à une température allant de 700°C à 1500°C, de préférence allant de 800°C à 1400°C, et de façon particulièrement préférée allant de 900°C à 1100°C ;
- sous une pression allant de 10⁻¹ mbar (millibar) à 10⁻⁸ mbar, de préférence allant de 10⁻² mbar à 10⁻⁶ mbar, et de façon particulièrement préférée allant de 10⁻³ mbar à 10⁻⁵ mbar ;
- pendant une durée allant de 1 s (seconde) à 30 min (minutes), de préférence allant de 5 s à 5 min, et de façon particulièrement préférée allant de 30 s à 50 s.

Pour ce faire, le cuivre métallique (Cu⁽⁰⁾) est positionné dans des filaments de tungstène et porté à l'état gazeux par effet Joule en appliquant une tension électrique aux bornes des filaments de tungstène. Le cuivre métallique (Cu⁽⁰⁾) est porté à l'état gazeux lorsque les filaments de tungstène ont atteint la température de chauffe.

A l'issu de l'étape ia, le cuivre métallique (Cu⁽⁰⁾) est déposé sur le support formant ainsi une couche qui présente un aspect métallisé.

Une fois l'étape ia réalisée et avant que l'oxydation de l'étape ib ne soit effectuée, la couche de cuivre métallique (Cu⁽⁰⁾) peut comprendre un peu d'oxyde de cuivre provenant de l'oxydation du cuivre métallique (Cu⁽⁰⁾) par des gaz résiduels présents lors du procédé.

L'étape ib d'oxydation du cuivre métallique (Cu⁽⁰⁾) peut être réalisée à une température allant de 50°C (par exemple lorsque le support est un polymère à faibles propriétés thermiques) à 1000 °C (par exemple lorsque le support est métallique), de préférence allant de 80 °C à 230 °C, et de façon particulièrement préférée allant de 120 °C à 160 °C. Pour cela, la pièce comprenant le support et la couche de cuivre métallique (Cu⁽⁰⁾), peut être placée dans un four traditionnellement utilisé pour ce type de procédé.

L'étape ib peut avoir une durée allant de 1 min à 100 h (heure), de préférence allant de 5 min à 40 min, et de façon particulièrement préférée allant de 10 min à 20 min.

L'étape ib permet avantageusement d'optimiser l'aspect métallisé de la couleur souhaitée, de façon à obtenir la couche métallisée de l'invention.

Comme exemple du premier mode de réalisation, on peut déposer une couche métallisée selon l'étape ia, sur un support de couleur noire. Cette couche métallisée présente alors un aspect sombre rosé correspondant, selon la méthode CIELab, aux valeurs de paramètres L*a*b* suivantes : 40 ≤L* ≤ 60, -2 ≤ a* ≤ +10, -5 ≤ b* ≤ +5. Ensuite, une fois l'étape ib d'oxydation réalisée, la couche métallisée présente un aspect bleu défini selon la méthode CIELab, par les valeurs de paramètres L*a*b* suivantes : 40 ≤ L* ≤ 60, -6 ≤ a* ≤ +2 et, -20 ≤ b* ≤ -10, et de préférence 45 ≤ L* ≤ 55, -4 ≤ a* ≤ 0 et, -18 ≤ b* ≤ -12.

Selon un deuxième mode de réalisation de l'invention, l'étape i du procédé de l'invention peut comprendre l'étape suivante :
ic. vaporiser le cuivre métallique (Cu⁽⁰⁾) sous une atmosphère oxydante pour former la couche métallisée sur au moins une partie du support, la couche métallisée étant formée par dépôt physique en phase vapeur.

Selon ce deuxième mode de réalisation, l'étape d'oxydation est réalisée au cours du dépôt physique en phase vapeur, et la couche métallisée est ainsi directement formée. En effet, selon ce deuxième mode de réalisation, le dépôt physique en phase vapeur est réalisé sous une atmosphère oxydante permettant d'oxyder le cuivre métallique dès son dépôt sur le support et/ou de l'oxyder juste avant son dépôt sur le support. Ce deuxième mode de réalisation présente l'avantage de former directement la couche métallisée en évitant une étape supplémentaire d'oxydation du cuivre métallique. Le procédé est ainsi plus rapide.

Selon ce deuxième mode de réalisation le procédé peut être réalisé :
- à une température allant de 700 °C à 1500 °C, de préférence allant de 800 °C à 1400 °C, et de façon particulièrement préférée allant de 900 °C à 1100 °C ;
- à une pression allant de 10⁻¹ mbar à 10⁻⁸ mbar, de préférence allant de 10⁻² mbar à 10⁻⁶ mbar, et de façon particulièrement préférée allant de 10⁻³ mbar à 10⁻⁵ mbar ;
- pendant une durée allant de 1 s à 30 min, de préférence allant de 5 s à 5 min, et de façon particulièrement préférée allant de 30 s à 50 s.

Le gaz oxydant utilisé lors du dépôt physique en phase vapeur réalisé à l'étape ic peut être un gaz à base d'oxygène comme, par exemple, de l'air, du dioxygène (O₂), de l'eau (H₂O), du protoxyde d'azote (N₂O), ou un de leurs mélanges.

De façon avantageuse, lors de l'étape ic, le rapport stoechiométrique entre l'oxygène du gaz oxydant et le cuivre déposé peut aller de 5% à 95%, de préférence aller de 10% à 90%, et de façon particulièrement préférée aller de 20% à 80%.

Lors de cette étape, l'oxyde de cuivre déposé ne doit pas être au contact d'une quantité trop importante d'humidité qui provoquerait sa corrosion. Cependant, la vapeur d'eau peut être utilisée comme gaz oxydant lors de l'étape ic sans pour autant dégrader l'oxyde de cuivre. En effet, la pression maximale étant de 10⁻¹ mbar, la quantité d'eau n'est pas suffisante pour dégrader la couche de cuivre.

Selon l'invention, le procédé peut en outre comprendre l'étape suivante :
ii. former sur au moins une partie de la couche métallisée de l'étape i ou de l'étape ic, ou sur au moins une partie de la couche de cuivre métallique (Cu⁽⁰⁾) de l'étape ia, une couche de protection.

L'étape ii peut ainsi être postérieure à l'étape i ou à l'étape ic, et/ou comprise entre les étapes ia et ib.

La couche de protection peut être formée selon différentes méthodes selon les composés qui la forment.

Selon une première variante, la couche de protection peut comprendre au moins un oxyde métallique et/ou au moins un complexe céramique, et peut par exemple être formée par dépôt physique en phase vapeur (PVD).

Selon cette première variante, le procédé peut être réalisé :
- à une température allant de 100 °C à 3500 °C, de préférence allant de 500 °C à 2500 °C, et de façon particulièrement préférée allant de 800 °C à 1500 °C ;
- à une pression allant de 10⁻¹ mbar à 10⁻⁸ mbar, de préférence allant de 10⁻² mbar à 10⁻⁶ mbar, et de façon particulièrement préférée allant de 10⁻³ mbar à 10⁻⁵ mbar ;
- pendant une durée allant de 1 s à 30 min, allant de préférence de 5 s à 5 min, et de façon particulièrement préférée allant de 30 s à 50 s.

Selon une deuxième variante, la couche de protection peut comprendre au moins un polysiloxane, ou plus particulièrement un polyorganosiloxane, et peut par exemple être formée par dépôt chimique en phase vapeur assisté par plasma connu sous l'anglicisme « Plasma-Enhanced Chemical Vapor Deposition » (PECVD) pour désigner des procédés dits « hors équilibre ». Ce type de dépôt est réalisé sous vide, plus précisément sous basse pression.

Selon cette deuxième variante, le procédé peut être réalisé :
- à une température allant de 30 °C à 200 °C, de préférence allant de 40 °C à 130 °C, et de façon particulièrement préférée allant de 50 °C à 100 °C ;
- à une pression allant de 10 mbar à 10⁻⁶ mbar, de préférence allant de 1 mbar à 10⁻⁴ mbar, et de façon particulièrement préférée allant de 5 x 10⁻² mbar à 10⁻⁴ mbar ;
- pendant une durée allant de 1 s à 500 s, de préférence allant de 5 s à 300 s, et de façon particulièrement préféré allant de 30 s à 240 s ;
- à une intensité de plasma allant de 50 mA (milliampère) à 5000 mA, de préférence allant de 100 mA à 2000 mA, et de façon particulièrement préférée allant de 200 mA à 1000 mA ; et
- à une tension de plasma allant de 500 V (volt) à 10000 V, de préférence allant de 1000 V à 8000 V, et de façon particulièrement préférée allant de 1500 V à 6000 V.

D'autres caractéristiques et avantages de la présente invention apparaîtront à la lumière de la description d'un exemple non limitatif d'une pièce métallisée selon l'invention, fait en référence à la figure suivante :

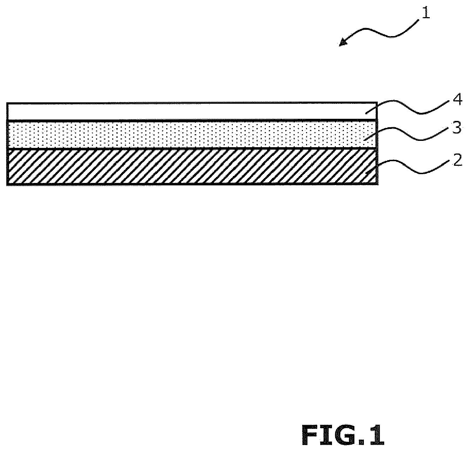

- La figure 1 représente une vue en coupe transversale d'une pièce métallisée selon un mode de réalisation particulier de l'invention.

Pour des raisons de clarté, seuls les éléments essentiels pour la compréhension de l'invention ont été représentés de manière schématique, et ceci sans respect de l'échelle.

La figure 1 représente une vue en coupe transversale d'une pièce métallisée 1 selon un mode de réalisation particulier de l'invention. La pièce métallisée 1 comprend un support 2 de couleur noire recouvert par une couche métallisée 3 comprenant au moins du cuivre et de l'oxygène. Selon ce mode de réalisation, la couche métallisée 3 est directement en contact physique avec le support 2, et recouvre totalement le support 2.

En outre, la couche métallisée 3 est recouverte d'une couche de protection 4 transparente. Dans ce mode de réalisation, la couche de protection 4 est directement en contact physique avec la couche métallisée 3, et recouvre totalement la couche métallisée 3.

Dans la présente invention, la couche de protection 4 est optionnelle, et la pièce métallisée 1 de l'invention peut comprendre uniquement le support 2 et la couche métallisée 3.

### Exemple de fabrication d'une pièce métallisée conforme à l'invention

Le support utilisé est un polycarbonate, commercialisé par la société Sabic, sous la référence Lexan XHT3141 (noir).

Ce support est un masque de module lumineux ayant une épaisseur variable de 2,5 mm à 3,0 mm.

### Etape ia

L'étape ia du procédé est tout d'abord réalisée avec du cuivre métallique (Cu⁽⁰⁾) commercialisé par la société Neyco, sous la référence « cuivre 99,9% ».

Le support est placé à l'intérieur de l'enceinte de la machine de métallisation sous vide. Le dépôt est alors réalisé par dépôt physique en phase vapeur (PVD) par évaporation thermique sous vide à une pression de 10⁻³ mbar et à une température de chauffe des charges de cuivre de 1300 °C.

Après environ 40 s d'évaporation, une couche de cuivre métallique (Cu⁽⁰⁾) d'une épaisseur moyenne de 25,0 nm est obtenue.

### Etape ii

L'étape ii de dépôt de la couche de protection est alors réalisée dans la même enceinte par un procédé de dépôt chimique en phase vapeur assisté par plasma (PECVD) en utilisant un précurseur de polysiloxane, qui est l'hexaméthyldisiloxane (HMDSO) commercialisé par la société Neyco, sous la référence NE-200, 0.65 cSt.

Le dépôt est réalisé :
- sous une pression de 3 x 10⁻² mbar ;
- à une température de 70°C ;
- à une intensité de plasma de 300 mA ;
- à une tension de plasma de 4800 V ; et
- pour une durée de 90 s.

La couche de protection déposée possède une épaisseur moyenne de 15,0 nm.

### Etape ib

La pièce comprenant le support, la couche de cuivre métallique (Cu⁽⁰⁾) ainsi que la couche de protection est ensuite placée dans un four industriel à convection à une température de 145 °C pour une durée de 15 min.

La couche de cuivre métallique (Cu⁽⁰⁾) est alors oxydée thermiquement à l'issue du dépôt PVD, permettant ainsi d'obtenir la couche métallisée d'oxyde de cuivre.

La pièce métallisée ainsi formée, comprenant le support, la couche métallisée et la couche de protection, est telle que représentée sur la figure 1.

## Revendications

1. Pièce métallisée (1) comprenant au moins un support (2), **caractérisée en ce qu'**elle comprend en outre au moins une couche métallisée (3) comprenant au moins du cuivre et de l'oxygène, la couche métallisée (3) recouvrant au moins en partie le support.

2. Pièce métallisée (1) selon la revendication 1, **caractérisée en ce que** le support (2) comprend au moins un matériau polymère.

3. Pièce métallisée (1) selon la revendication 1 ou 2, **caractérisée en ce que** le matériau polymère du support (2) comprend au moins un polymère choisi parmi le polycarbonate (PC), le polyméthacrylate de méthyle (PMMA), le polymère acrylonitrile butadiène styrène (ABS), le polytéréphtalate de butylène (PBT), le polyéthylène (PE), le polypropylène (PP), le polyamide (PA), et un de leurs mélanges.

4. Pièce métallisée (1) selon l'une quelconque des revendications 1 à 3, **caractérisée en ce que** la couche métallisée (3) comprend un ou plusieurs groupement(s) cuivre-oxygène (Cu-O).

5. Pièce métallisée (1) selon l'une quelconque des revendications 1 à 4, **caractérisée en ce que** la couche métallisée (3) comprend au moins un oxyde de cuivre.

6. Pièce métallisée (1) selon l'une quelconque des revendications 1 à 5, **caractérisée en ce que** l'oxyde de cuivre est choisi parmi l'oxyde de cuivre (I) (Cu₂O), l'oxyde de cuivre (II) (CuO), et un de leurs mélanges.

7. Pièce métallisée (1) selon l'une quelconque des revendications 1 à 6, **caractérisée en ce que** la couche métallisée (3) est directement en contact physique avec le support (2).

8. Pièce métallisée (1) selon l'une quelconque des revendications 1 à 7, **caractérisée en ce qu'**elle comprend en outre une couche de protection (4) recouvrant au moins en partie la couche métallisée (3).

9. Pièce métallisée selon la revendication 8, **caractérisée en ce que** la couche de protection (4) est transparente.

10. Pièce métallisée (1) selon la revendication 8 ou 9, **caractérisée en ce que** la couche de protection (4) est directement en contact physique avec la couche métallisée (3).

11. Pièce métallisée (1) selon l'une quelconque des revendications 8 à 10, **caractérisée en ce que** la couche de protection (4) peut comprendre au moins un oxyde métallique, au moins un complexe céramique et/ou au moins un matériau polymère.

12. Pièce métallisée (1) selon la revendication 11, **caractérisée en ce que** l'oxyde métallique est choisi parmi le dioxyde de titane (TiO₂), l'oxyde de zinc (ZnO), et un de leurs mélanges.

13. Pièce métallisée (1) selon la revendication 11, **caractérisée en ce que** le complexe céramique est choisi parmi le fluorure de magnésium (MgF₂), le dioxyde de silane (SiO₂), le dioxyde de zirconium (ZrO₂), le nitrure de silane (Si₃N₄), et un de leurs mélanges.

14. Pièce métallisée (1) selon la revendication 11, **caractérisée en ce que** le matériau polymère est choisi parmi un polymère acrylique, un polysiloxane, un polyuréthane, et un de leurs mélanges.

15. Pièce métallisée (1) selon la revendication 14, **caractérisée en ce que** le polysiloxane a pour précurseur au moins un siloxane choisi parmi l'hexaméthyldisiloxane (HMDSO), octaméthylcyclotétrasiloxane (OMCTSO), le tétraméthyldisiloxane (TMDSO), le tétraéthyl orthosilicate (TEOS), et un de leurs mélanges.

16. Pièce métallisée (1) selon l'une quelconque des revendications 1 à 15, **caractérisée en ce que** le support (2) a, selon la méthode CIELab, les valeurs de paramètres L*a*b* suivantes : 25 ≤ L* ≤ 30, -1 ≤ a* ≤ +1 et, -1 ≤ b* ≤ +1 le paramètre L* définissant la clarté et les paramètres a* et b* définissant la chromaticité.

17. Procédé de fabrication d'une pièce métallisée (1) selon l'une quelconque des revendications 1 à 16, **caractérisée en ce qu'**il comprend l'étape suivante :
i. former à partir de cuivre métallique (Cu⁽⁰⁾), sur au moins une partie du support (2), la couche métallisée (3) comprenant au moins du cuivre et de l'oxygène, l'étape i comprenant au moins une étape de dépôt physique en phase vapeur.

18. Procédé de fabrication selon la revendication 17, **caractérisé en ce que** l'étape i comprend les étapes suivantes :
ia. déposer une couche de cuivre métallique (Cu⁽⁰⁾), sur au moins une partie du support (2), par dépôt physique en phase vapeur du cuivre métallique (Cu⁽⁰⁾), et
ib. oxyder le cuivre métallique (Cu⁽⁰⁾) de la couche déposée à l'étape ia pour former la couche métallisée (3).

19. Procédé de fabrication selon la revendication 17, **caractérisé en ce que** l'étape i comprend l'étape suivante :
ic. vaporiser le cuivre métallique (Cu⁽⁰⁾) sous une atmosphère oxydante pour former la couche métallisée (3) sur au moins une partie du support (2), la couche métallisée (3) étant formée par dépôt physique en phase vapeur.

20. Procédé de fabrication selon l'une quelconque des revendications 17 à 19, comprenant en outre l'étape suivante :
former sur au moins une partie de la couche métallisée (3) de l'étape i ou de l'étape ic, ou sur au moins une partie de la couche de cuivre métallique (Cu⁽⁰⁾) de l'étape ia, une couche de protection (4).
